# EUROPEAN PATENT APPLICATION

(11) **EP 2 482 459 A1**
(43) Date of publication of application: **01.08.2012**
(21) Application number: 11290060.0
(22) Date of filing: 28.01.2011
(51) Int. Cl.: H03L 5/00, H03L 3/00, H04B 1/04

(54) **Oscillator amplitude control**

(71) Applicant: NXP B.V., 5656 AG Eindhoven (NL)
(72) Inventor: Wane, Sidina, 5656 AE Eindhoven (NL); Elkassir, Bilal, 5656 AE Eindhoven (NL); Philippe, Pascal, 5656 AE Eindhoven (NL); Gamand, Patrice, 5656 AE Eindhoven (NL)
(74) Representative: Schouten, Marcus Maria

(57) **Abstract**

A method for controlling the amplitude of oscillation of an oscillator (1) is disclosed. The method comprises:
a) using a first regulation circuit (2) to generate an error value (30) representing the difference between the amplitude of oscillation and a reference value; and
b) adjusting an amplitude regulation setting (31) of the oscillator (1) to vary the amplitude of oscillation such that the error value is minimised; characterised in that the method further comprises:
c) monitoring the error value and a corresponding value of the amplitude regulation setting (32);
d) comparing the error value with a predetermined threshold (33); and
e) when the error value falls below the predetermined threshold, disabling the first regulation circuit and maintaining the amplitude regulation setting (34).

## Description

The invention relates to a method and apparatus for controlling the amplitude of oscillation of an oscillator.

Many types of oscillator are stabilised by amplitude level control (ALC) or automatic gain control (AGC) circuits, which ensure that the amplitude of oscillation remains within acceptable limits. Such stabilisation brings with it many advantages. These include ensuring reliable start-up of the oscillator along with an optimised settling time; ensuring an optimum trade-off between low noise biasing conditions and oscillation settling time; maintainting stable output amplitude level over a wide temperature range and with process variations; and ensuring that non-linear components operate with low harmonic distortion.

However, there are also various drawbacks inherent with the use of this kind of stabilisation circuit. These drawbacks include the presence of potential noise and spurious signal modulation effects through the feedback control loop of the AGC; and an increase in power consumption due to the presence of the AGC.

According to the invention, there is provided a method for controlling the amplitude of oscillation of an oscillator, the method comprising:
a) using a first regulation circuit to generate an error value representing the difference between the amplitude of oscillation and a reference value; and
b) adjusting an amplitude regulation setting of the oscillator to vary the amplitude of oscillation such that the error value is minimised;
   characterised in that the method further comprises:
c) monitoring the error value and a corresponding value of the amplitude regulation setting;
d) comparing the error value with a predetermined threshold; and
e) when the error value falls below the predetermined threshold, disabling the first regulation circuit and maintaining the amplitude regulation setting.

Hence, by disabling the first regulation circuit when the oscillator has achieved stable operation and maintaining the amplitude by other means, it is possible to dramatically reduce the power consumed by the regulation circuit and to prevent it from introducing noise and spurious signal modulation effects. The above-mentioned problems are therefore overcome.

The first regulation circuit is preferably disabled by removing power from the first regulation circuit. This maximises the power saving provided by the invention.

Alternatively, or in addition, the first regulation circuit may be disabled by disconnecting the oscillator from the first regulation circuit.

In one embodiment, the step of maintaining the amplitude regulation setting comprises memorising the value of the amplitude regulation setting when the error value falls below the predetermined threshold and causing the amplitude regulation setting to remain at the memorised value.

In a particularly advantageous embodiment, the method further comprises enabling a second regulation circuit when the error value falls below the predetermined threshold, the first and second regulation circuits being optimised for efficient start-up and low-power operation respectively. Being optimised for low-power operation, this second regulation circuit can provide many of the advantages of a traditional AGC without excessive power consumption. The first regulation circuit, operating at higher currents, will handle the job of ensuring quick start-up of the oscillator.

In accordance with a second aspect of the invention, there is provided apparatus for controlling the amplitude of oscillation of an oscillator, the apparatus comprising a regulation circuit adapted to generate an error value representing the difference between the amplitude of oscillation and a reference value; an amplitude adjustment circuit adapted to adjust an amplitude regulation setting of the oscillator to vary the amplitude of oscillation such that the error value is minimised; characterised in that the apparatus further comprises a controller circuit adapted to monitor the error value and a corresponding value of the amplitude regulation setting; compare the error value with a predetermined threshold; and when the error value falls below the predetermined threshold, disable the regulation circuit and maintain the amplitude regulation setting.

Preferably, the controller circuit is adapted to disable the first regulation circuit by opening a first switch, thereby removing power from the first regulation circuit.

Alternatively, or in addition, the controller circuit may be adapted to disable the first regulation circuit by opening a second switch, thereby disconnecting the oscillator from the first regulation circuit.

In one embodiment, the controller circuit comprises a memory, the controller circuit being adapted to maintain the amplitude regulation setting by storing the value of the amplitude regulation setting in the memory when the error value falls below the predetermined threshold and causing the amplitude regulation setting to remain at the memorised value.

In this embodiment, the controller circuit may be adapted to cause the amplitude regulation setting to remain at the memorised value using the amplitude adjustment circuit.

In a particularly advantageous embodiment, the controller circuit is further adapted to enable a second regulation circuit when the error value falls below the predetermined threshold, the first and second regulation circuits being optimised for efficient start-up and low-power operation respectively.

In this case, the first regulation circuit is typically a current mode logic (CML) circuit and the second regulation circuit is typically a metal oxide semiconductor (MOS) circuit.

Examples of the invention will now be described in detail with reference to the accompanying drawings, in which:
Figure 1 shows a block diagram of an oscillator comprising a control circuit for controlling the amplitude of oscillation;
Figure 2 shows a block diagram of a variant of the control circuit; and
Figure 3 shows a flow diagram of the method performed by the invention.

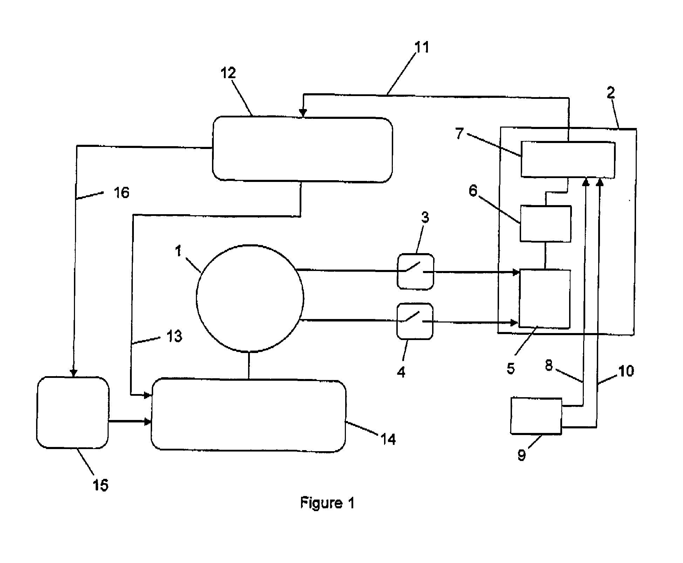

Figure 1 shows an oscillator 1 coupled to a regulator circuit 2 via switches 3, 4. When power is first applied to the oscillator 1, the switches 3, 4 are closed and the amplitude of oscillation is controlled by the regulator circuit 2.

In the regulator circuit 2, a detector module 5 detects the amplitude of the output signal generated by oscillator 1. The output of the detector module 5 is fed via an integrator 6 to a comparator module 7, which compares the detected signal with a reference signal 8. The reference signal 8 is supplied from a digital-to-analogue converter (DAC) 9. The DAC 9 also supplies a comparator gain signal 10 to the comparator module 7. This signal can be used to adjust the gain of the comparator depending on the value of reference signal 8; a higher comparator gain will be set when it is desired to have a lower error between the reference signal 8 and the signal from the integrator 6.

The comparator module 7 compares the signal from the integrator 6 with reference signal 8 and generates an error signal 11, which represents the difference between the reference signal 8 and the signal from the integrator 6 (and hence, the amplitude of the oscillator output). The error signal 11 is supplied to a control circuit 12, implemented as a digital state machine in this embodiment.

The control circuit 12 comprises an amplitude adjustment circuit, which adjusts an amplitude regulation setting depending on the value of the error signal 11. The amplitude regulation setting is chosen to reduce the error value to a minimum. Typically, this process will take a short while after the oscillator 1 is powered on whilst the circuitry reaches a stable equilibrium state. Once the stable state is reached, the oscillator 1 will produce an output that is constant and controlled. The amplitude regulation setting is supplied as an output signal 13 to an oscillator amplitude control circuit 14.

This controls the amplitude of the oscillator output depending on the signal received from the control circuit 12. It does this by adjusting one of the current flowing into the control input of the oscillator 1, the voltage on the control input of the oscillator 1, or the impedance on the control input of the oscillator 1. Which of these variants is used will depend on the construction of the oscillator 1.

The control circuit 12 also comprises a monitoring circuit, which monitors the error value and compares it with a predetermined threshold. The threshold is set at a value which indicates that the stable equilibrium state has been reached. Thus, when the monitoring value detects that the error value has fallen below the predetermined threshold, it causes a memory within the control circuit 12 to memorise the value of the amplitude regulation setting.

This value of amplitude regulation setting is then output from the control circuit 12 as output signal 13 to maintain the amplitude regulation setting at the value it was at when the error value fell below the predetermined threshold. This ensures that the oscillator amplitude control circuit 14 controls the oscillator 1 such that its output amplitude will be at the correct, desired level.

The control circuit 12 also opens switches 3, 4 to disconnect the regulation circuit 2 from the oscillator 1. This ensures that there is no noise and spurious signal modulation effects due to the regulation circuit 2 introduced into the oscillator output. Typically, the control circuit 12 will also remove power from the regulation circuit 2 to lower the power consumption of the overall circuit.

The control circuit 12 may also be coupled to a start-up boost circuit 15, which causes the oscillator amplitude control circuit 14 to demand an artificially high level of output amplitude from the oscillator 1 during a start-up phase. This helps to ensure rapid start-up and stabilisation of the oscillator output amplitude. The control circuit 12 disables the start-up boost circuit 15 after the start-up phase by way of a start-up boost disable signal 16, which causes the start-up boost circuit 15 to power down. The end of the start-up phase is detected by monitoring for a stable oscillator output, for example by detecting when the oscillator output amplitude has remained within a tolerance band of a desired value for a predefined length of time. An additional security delay may be added from when the stable oscillator output is detected before the boost circuit 15 is disabled.

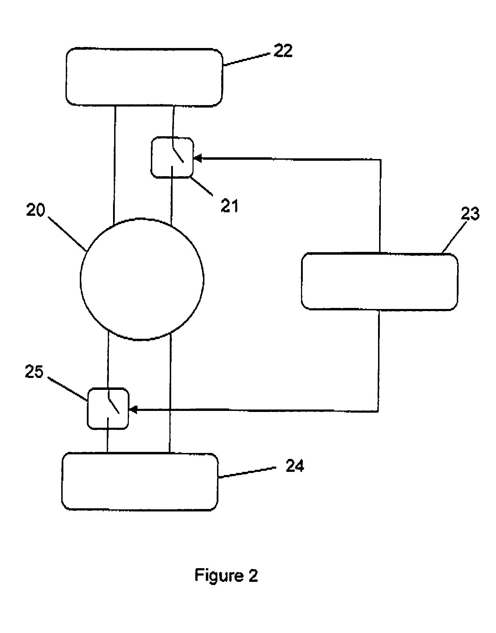

Figure 2 shows a variant of the embodiment of Figure 1, which comprises a second regulation circuit. In Figure 2, an oscillator 20 is coupled via a switch 21 to a first regulator circuit 22. This first regulator circuit 22 is based on CML technology, and ensures rapid start-up and stabilisation at the cost of high power consumption. A control circuit 23 monitors an error value produced by the first regulator circuit 22 and opens switch 21 when a stable equilibrium state has been reached. To this point, the operation is the same as that of the circuit of Figure 1.

However, at the same time as the first regulation circuit 22 is disabled a second regulation circuit 24 is enabled by closing switch 25. The second regulation circuit 24 takes over the function of controlling the amplitude of oscillation. The second regulation circuit 24 is based on MOS technology. It therefore operates at a much lower current and with a lower phase noise than the first regulator circuit 22.

Therefore, this variant is useful since it provides rapid start-up using the first regulator circuit 22 and relatively low power consumption and phase noise using the second regulator circuit 24. Unlike the embodiment of Figure 1, there is always active control of the amplitude by one or other of the first and second regulation circuit 22, 24, and the output amplitude of oscillator 20 is less affected by temperature changes and the like, which may occur after the control circuit 12 has disabled the regulation circuit 2 in the Figure 1 embodiment.

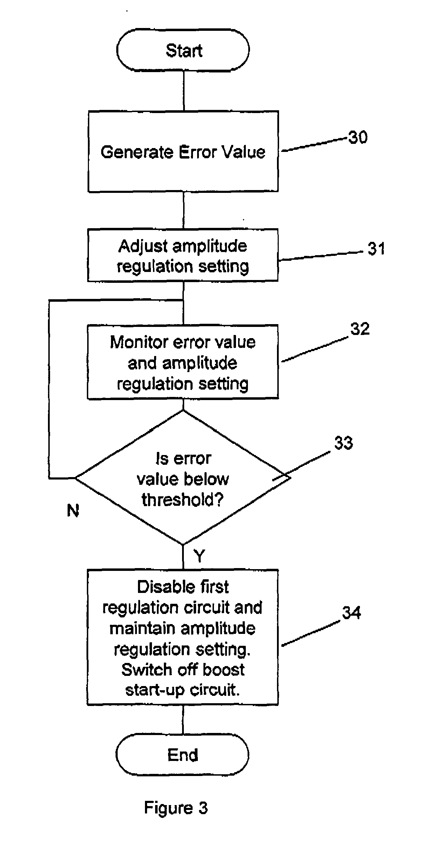

Figure 3 shows a flow chart of the method carried out by the circuits of Figures 1 and 2. In step 30, an error value is generated by the first regulation circuit. The error value represents the difference between the amplitude of oscillation and a reference value. Then, in step 31, the amplitude regulation setting is adjusted depending on the error value in order to minimise the error value.

The control circuit 12, 23 monitors the error value and the corresponding value of the amplitude regulation setting in step 22 and determines, in step 23, whether the error value is below a predetermined threshold. As described above, the predetermined threshold represents the point at which the amplitude of oscillation has reached a stable point at the desired amplitude. If the error value is not below the threshold then the monitoring and comparing process of steps 22 and 23 is repeated.

If, on the other hand, the error value is below the threshold then in step 34 the first regulation circuit will be disabled (by removing power from it, disconnecting it from the oscillator, or both), and the amplitude regulation setting will be maintained by memorising its value at the point that the error value fell below the threshold. The boost start-up circuit is also disabled. The oscillator can then be controlled in accordance with this amplitude regulation setting to maintain the amplitude of oscillation at the desired, stable level.

If the embodiment of Figure 2 is used then step 34 will also include the step of enabling the second regulation circuit 24.

Other variations to the disclosed embodiments can be understood and effected by those skilled in the art in practising the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. Any reference signs in the claims should not be construed as limiting the scope.

## Claims

1. A method for controlling the amplitude of oscillation of an oscillator (1), the method comprising:
a) using a first regulation circuit (2) to generate an error value (30) representing the difference between the amplitude of oscillation and a reference value; and
b) adjusting an amplitude regulation setting (31) of the oscillator (1) to vary the amplitude of oscillation such that the error value is minimised; **characterised in that** the method further comprises:
c) monitoring the error value and a corresponding value of the amplitude regulation setting (32);
d) comparing the error value with a predetermined threshold (33); and
e) when the error value falls below the predetermined threshold, disabling the first regulation circuit and maintaining the amplitude regulation setting (34).

2. A method according to claim 1, wherein the first regulation circuit (2) is disabled by removing power from the first regulation circuit.

3. A method according to claim 1 or claim 2, wherein the first regulation circuit (2) is disabled by disconnecting the oscillator from the first regulation circuit.

4. A method according to any of the preceding claims, wherein the step of maintaining the amplitude regulation setting comprises memorising the value of the amplitude regulation setting when the error value falls below the predetermined threshold and causing the amplitude regulation setting to remain at the memorised value.

5. A method according to any of the preceding claims, further comprising enabling a second regulation circuit (24) when the error value falls below the predetermined threshold, the first (2) and second (24) regulation circuits being optimised for efficient start-up and low-power operation respectively.

6. Apparatus for controlling the amplitude of oscillation of an oscillator (1), the apparatus comprising a regulation circuit (2) adapted to generate an error value representing the difference between the amplitude of oscillation and a reference value; an amplitude adjustment circuit adapted to adjust an amplitude regulation setting of the oscillator (1) to vary the amplitude of oscillation such that the error value is minimised; **characterised in that** the apparatus further comprises a controller circuit (12) adapted to monitor the error value and a corresponding value of the amplitude regulation setting; compare the error value with a predetermined threshold; and when the error value falls below the predetermined threshold, disable the first regulation circuit (2) and maintain the amplitude regulation setting.

7. Apparatus according to claim 6, wherein the controller circuit (12) is adapted to disable the first regulation circuit (2) by opening a first switch, thereby removing power from the first regulation circuit (2).

8. Apparatus according to claim 6 or claim 7, wherein the controller circuit (12) is adapted to disable the first regulation circuit (2) by opening a second switch (3, 4), thereby disconnecting the oscillator (1) from the first regulation circuit (12).

9. Apparatus according to any of claims 6 to 8, wherein the controller circuit (12) comprises a memory, the controller circuit (12) being adapted to maintain the amplitude regulation setting by storing the value of the amplitude regulation setting in the memory when the error value falls below the predetermined threshold and causing the amplitude regulation setting to remain at the memorised value.

10. Apparatus according to claim 9, wherein the controller circuit (12) is adapted to cause the amplitude regulation setting to remain at the memorised value using the amplitude adjustment circuit.

11. Apparatus according to any of claims 7 to 10, wherein the controller circuit (23) is further adapted to enable a second regulation circuit (24) when the error value falls below the predetermined threshold, the first (22) and second (24) regulation circuits being optimised for efficient start-up and low-power operation respectively.

12. Apparatus according to claim 11, wherein the first regulation circuit (22) is a current mode logic (CML) circuit and the second regulation circuit (24) is a metal oxide semiconductor (MOS) circuit.
